(19) Europäisches Patentamt
European Patent Office
Office européen des brevets

(11) **EP 3 252 616 A1**

(12) **EUROPEAN PATENT APPLICATION**

(43) Date of publication:
**06.12.2017 Bulletin 2017/49**

(51) Int Cl.:
*G06F 17/18* (2006.01)       *G01R 31/36* (2006.01)

(21) Application number: **16172548.6**

(22) Date of filing: **01.06.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Honeywell spol s.r.o.**
**14800 Prague 4 (CZ)**

(72) Inventors:
• **TRNKA, Pavel**
 **Morris Plains, NJ New Jersey 07950 (US)**

• **HAVLENA, Vladimir**
 **Morris Plains, NJ New Jersey 07950 (US)**
• **SALAJ, Michal**
 **Morris Plains, NJ New Jersey 07950 (US)**

(74) Representative: **Houghton, Mark Phillip**
 **Patent Outsourcing Limited**
 **1 King Street**
 **Bakewell, Derbyshire DE45 1DZ (GB)**

Remarks:
Amended claims in accordance with Rule 137(2) EPC.

(54) **ESTIMATING VARIABLES THAT ARE NOT DIRECTLY MEASURABLE**

(57)    Devices, methods, and systems for estimating variables that are not directly measurable are described herein. One device includes a memory, and a processor configured to execute executable instructions stored in the memory to estimate a number of variables that are not directly measurable using an inferential sensor with a model having a number of uncertain parameters associated therewith, wherein the model describes a relationship between the number of variables to be estimated and a number of directly measurable variables, and a number of constraints on the number of variables to be estimated.

*Fig. 2*

## Description

Technical Field

The present disclosure relates to devices, methods, and systems for estimating variables that are not directly measurable.

Background

Inferential (e.g., virtual) sensors can be used to estimate variables that are not directly measurable by using measurements of other variables that are related to (e.g., correlated with) the variable(s) to be estimated. As an example, the remaining charge of a battery may be an internal state of the battery that is not directly measurable, but can be estimated by an inferential sensor using the voltage, current, and/or temperature associated with battery, all of which can be directly measured (e.g., sensed).

One type of inferential sensor is a Kalman filter, which may use a model-based approach to estimate variables that are not directly measurable. For example, a Kalman filter may use a mathematical model that describes a relationship (e.g., a dynamical coupling) between the variable to be estimated and the variable(s) related to that variable that can be directly measured.

Brief Description of the Drawings

Figure 1 illustrates a computing device for estimating variables that are not directly measurable in accordance with one or more embodiments of the present disclosure.

Figure 2 illustrates an inferential sensor for estimating variables that are not directly measurable in accordance with one or more embodiments of the present disclosure.

Figure 3 illustrates a system for estimating variables that are not directly measurable in accordance with one or more embodiments of the present disclosure.

Detailed Description

Devices, methods, and systems for estimating variables that are not directly measurable are described herein. For example, one or more embodiments include a memory, and a processor configured to execute executable instructions stored in the memory to estimate a number of variables that are not directly measurable using an inferential sensor with a model having a number of uncertain parameters associated therewith, wherein the model describes a relationship between the number of variables to be estimated and a number of directly measurable variables, and a number of constraints on the number of variables to be estimated.

Embodiments of the present disclosure can provide more accurate and/or precise estimations of variables that are not directly measurable than previous approaches. For example, embodiments of the present disclosure can provide more accurate and/or precise estimations of variables that are not directly measurable by combining a model-based inferential sensor, such as a Kalman filter for models with uncertain parameters, with a moving horizon estimator (MHE) that can incorporate constraints on the variable to be estimated.

In the following detailed description, reference is made to the accompanying drawings that form a part hereof. The drawings show by way of illustration how one or more embodiments of the disclosure may be practiced.

These embodiments are described in sufficient detail to enable those of ordinary skill in the art to practice one or more embodiments of this disclosure. It is to be understood that other embodiments may be utilized and that process, electrical, and/or structural changes may be made without departing from the scope of the present disclosure.

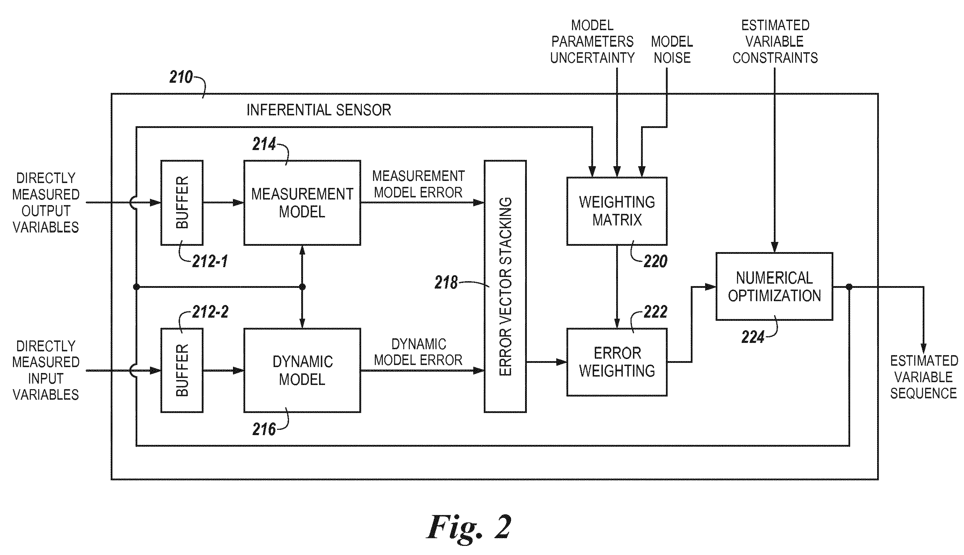

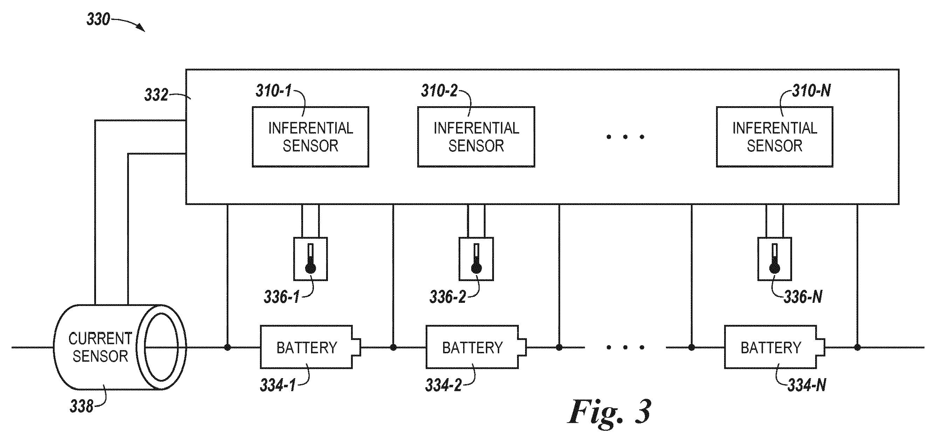

The figures herein follow a numbering convention in which the first digit or digits correspond to the drawing figure number and the remaining digits identify an element or component in the drawing. Similar elements or components between different figures may be identified by the use of similar digits. For example, 210 may reference element "10" in Figure 2, and a similar element may be referenced as 310 in Figure 3.

As will be appreciated, elements shown in the various embodiments herein can be added, exchanged, combined, and/or eliminated so as to provide a number of additional embodiments of the present disclosure. The proportion and the relative scale of the elements provided in the figures are intended to illustrate the embodiments of the present disclosure, and should not be taken in a limiting sense.

As used herein, the designator "N", particularly with respect to the reference numerals in the drawings, indicates that a number of the particular feature so designated can be included. As used herein, "a" or "a number of" something can refer to one or more such things. For example, "a number of variables" can refer to one or more variables.

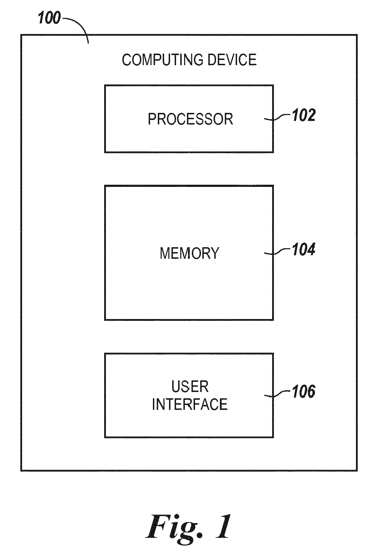

Figure 1 illustrates a computing device 100 for estimating variables that are not directly measurable in accordance with one or more embodiments of the present disclosure. Computing device 100 can be, for example, a laptop computer, desktop computer, or mobile device (e.g., smart phone, tablet, PDA, etc.), among other types of computing devices. Computing device 100 may also be, include, and/or be a portion of an inferential sensor, as will be further described herein.

As shown in Figure 1, computing device 100 can include a memory 104 and a processor 102. Memory 104 can be any type of storage medium that can be accessed by processor 102 to perform various examples of the present disclosure. For example, memory 104 can be a non-transitory computer readable medium having computer readable instructions (e.g., computer program instructions) stored thereon that are executable by processor 102 to estimate a variable that is not directly measurable in accordance with the present disclosure. That is, processor 102 can execute the executable instructions stored in memory 104 to estimate a variable that is not directly measurable in accordance with the present disclosure.

Memory 104 can be volatile or nonvolatile memory. Memory 104 can also be removable (e.g., portable) memory, or non-removable (e.g., internal) memory. For example, memory 104 can be random access memory (RAM) (e.g., dynamic random access memory (DRAM) and/or phase change random access memory (PCRAM)), read-only memory (ROM) (e.g., electrically erasable programmable read-only memory (EEPROM) and/or compact-disk read-only memory (CD-ROM)), flash memory, a laser disk, a digital versatile disk (DVD) or other optical disk storage, and/or a magnetic medium such as magnetic cassettes, tapes, or disks, among other types of memory.

Further, although memory 104 is illustrated as being located in computing device 100, embodiments of the present disclosure are not so limited. For example, memory 104 can also be located internal to another computing resource (e.g., enabling computer readable instructions to be downloaded over the Internet or another wired or wireless connection).

As shown in Figure 1, computing device 100 can include a user interface 106. A user (e.g., operator) of computing device 100 can interact with computing device 100 via user interface 106. For example, user interface 106 can provide (e.g., display and/or present) information to the user of computing device 100, such as, for instance, a variable that has been estimated in accordance with the present disclosure. Further, user interface 106 can receive information from (e.g., input by) the user of computing device 100.

In some embodiments, user interface 106 can be a graphical user interface (GUI) that can include a display (e.g., a screen) that can provide and/or receive information to and/or from the user of computing device 100. The display can be, for instance, a touch-screen (e.g., the GUI can include touch-screen capabilities). As an additional example, user interface 106 can include a keyboard and/or mouse the user can use to input information into computing device 100. Embodiments of the present disclosure, however, are not limited to a particular type(s) of user interface.

As an additional example, computing device 100 can be, include, and/or be a portion of one or more controllers, such as one or more microcontrollers. A controller (e.g., a microcontroller) can include logic. As used herein, "logic" is an alternative or additional processing resource to execute the actions and/or functions, etc., described herein, which can include hardware (e.g., various forms of transistor logic, application specific integrated circuits (ASICs), etc.), as opposed to computer executable instructions (e.g., software, firmware, etc.) stored in memory and executable by a processor.

As such, "computing device 100" can refer to a computing device (e.g., laptop computer, desktop computer, or mobile device) having a processor, memory, and user interface (e.g., processor 102, memory 104, and user interface 106), and/or to a controller having logic, to perform and/or execute the actions and/or functions, etc., described herein.

As an example, computing device 100 can estimate a variable (e.g., a value of the variable) that is not directly measurable using an inferential (e.g., virtual) sensor with a model having a number of uncertain parameters associated therewith, and a number of constraints on the variable to be estimated. The model can be, for example, a mathematical model that describes a relationship, such as, for instance, a dynamical coupling, between the variable to be estimated (e.g., the variable that is not directly measurable) and a number of directly measurable variables. An example of such a model will be further described herein (e.g., in connection with Figure 2).

The number of directly measurable variables can be directly measurable variables that are related to (e.g., correlated with) the variable that is not directly measurable, and can provide partial and/or noisy information about the variable that is not directly measurable. That is, the value of the variable that is not directly measurable may depend on, and hence can be estimated based on, the value(s) of the variables that are directly measurable. In some embodiments, the direct measurement of the variables can be performed by, and received by computing device 100 from, a number of sensors.

As used herein, a directly measurable variable can refer to a variable that can be independently determined (e.g., measured, sensed, and/or acquired) without the use or measurement of any other variable In contrast, a variable that is not directly measurable can refer to a variable that can not be directly measured itself, and instead must be estimated by using and/or measuring some other variable or variables. As an example, a variable that is not directly measurable may be an internal state of a battery, such as, for instance, the remaining charge of the battery, and directly measurable variables can include characteristics associated with the battery that can be used to estimate the internal state of the battery, such as, for instance, the voltage, current, and/or temperature associated with the battery. Such an example will be further described herein (e.g., in connection with Figure 3).

The uncertain parameters associated with the model can be parameters that are described by their probability distributions (e.g., by their mean value and covariance), and are not updated by new measurements of the directly measurable variables. For instance, continuing with the battery example, uncertain parameters can include parameters associated with the battery that may have manufacturing variability (e.g., parameters that capture and/or may vary due to manufacturing variability in the battery) such as, for instance, the capacity and the internal resistance associated with the battery.

In contrast to uncertain parameters, parameters could be assumed to be constant and/or known (e.g., constant parameters), and/or could be described by their probability distributions and updated by each new measurement (e.g., estimated parameters). However, treating parameters as uncertain can improve the robustness of the inferential sensor of the present disclosure in comparison to a standard Kalman filter because, for example, estimating more than a particular number and/or ratio of parameters can yield inaccuracies (e.g., inaccuracies resembling overfitting).

The constraints on the variable to be estimated can include a number of physical constraints on the variable to be estimated, and/or a number of constraints on the validity range of the model. For instance, continuing with the battery example, a constraint on the internal state of the battery may be a constraint of 0% to 100% on the remaining charge of the battery, since it is not possible for the remaining charge of the battery to be less than 0% or greater than 100%.

The MHE may include (e.g., may be formulated with and use) a non-diagonal weighting matrix to minimize errors associated with the model, such as, for instance, weighted measurement model errors and/or dynamic model errors. For example, in some embodiments, the MHE may include a non-diagonal weighting matrix that can minimize a mean square error of an estimated state sequence for the model. For instance, the weighting matrix may be based on the model parameters uncertainty description and the model noise description, such that the mean square error of the estimated state sequence is minimized. An example of such a non-diagonal weighting matrix will be further described herein (e.g., in connection with Figure 2).

In contrast, previous MHE approaches may include a simple diagonal weighting matrix. By including a non-diagonal weighting matrix, embodiments of the present disclosure can provide a more accurate and/or precise estimate of the variable that is not directly measurable.

In some embodiments, computing device 100 can estimate the variable that is not directly measurable based on a current direct measurement of each respective directly measurable variable, and a number of previous (e.g., historic) direct measurements of each respective directly measurable variable. For instance, the inferential sensor may use both current and previous measurements of the directly measurable variables to estimate the variable that is not directly measurable.

Further, in some embodiments the estimation of the variable that is not directly measurable may include an estimate of the current state of the variable, and a prediction of a future (e.g., next) state of the variable. For instance, estimating the variable that is not directly measurable may include estimating a state sequence that includes both the current state of the variable and a prediction of the future state(s) of the variable. An example of such an estimated state sequence will be further described herein (e.g., in connection with Figure 2).

The estimate of the variable can be displayed to the user of computing device 100 on user interface 106. Additionally or alternatively, the estimate of the variable can be stored in memory 104, such as, for instance, in a database stored in memory 104.

Figure 2 illustrates an inferential sensor 210 for estimating variables that are not directly measurable in accordance with one or more embodiments of the present disclosure. Inferential sensor 210 can be, include, and/or be a portion of computing device 100 previously described in connection with Figure 1, for example.

Inferential sensor 210 can include a number of first in, first out (FIFO) buffers that can each receive and store direct measurements of a different variable. For example, in the embodiment illustrated in Figure 2, inferential sensor 210 includes a first FIFO buffer 212-1 that can receive and store direct measurements of directly measurable input variables, and a second FIFO buffer 212-2 that can receive and store direct measurements of directly measurable output variables.

Each respective buffer (e.g., buffers 212-1 and 212-2) can store up to N measurements. When a new measurement is received by a buffer that is currently storing N measurements, the new measurement can replace the oldest measurement in the buffer.

As shown in Figure 2, inferential sensor 210 can include a measurement model 214 and a dynamic model 216 that can receive inputs and outputs from buffers 212-1 and 212-2, respectively. Dynamic model 216 and measurement model 214 can be respectively described by:

$$\mathbf{x}_{k+1} = f(\mathbf{x}_k, \mathbf{u}_k, \boldsymbol{\rho}) + \mathbf{v}_k,$$

$$\mathbf{y}_k = g(\mathbf{x}_k, \mathbf{u}_k, \boldsymbol{\rho}) + \mathbf{e}_k,$$

where $\mathbf{x}_k$ is an $n$-dimensional vector of a system state (directly unmeasurable variables), $\mathbf{u}_k$ is an $m$-dimensional vector of system input,

$\mathbf{y}_k$ is an $r$-dimensional vector of system output (directly measurable variables), $\rho$ is a $p$-dimensional vector of uncertain model parameters,

$\mathbf{v}_k$ is an $n$-dimensional vector of process noise, $\mathbf{e}_k$ is an $r$-dimensional vector of measurement noise, $f$ is a function describing system dynamics, and $g$ is a function describing measurement. It will be assumed that the process noise is a zero-mean white noise with variance

$\mathbf{Q}_k$ where:

$$\mathbf{v}_k \sim N(\mathbf{0}, \mathbf{Q}_k),$$

the measurement noise is a zero-mean white noise with variance $\mathbf{R}_k$

$$\mathbf{e}_k \sim N(\mathbf{0}, \mathbf{R}_k),$$

and the uncertain parameters have mean value $\hat{\rho}$ and covariance $\mathbf{P}^\rho$

$$\boldsymbol{\rho} \sim N(\hat{\boldsymbol{\rho}}, \mathbf{P}^\rho).$$

The uncertain parameters are constant in time. However, the specific values of the uncertain parameters are unknown, and are described only by their mean values and covariance matrix. They may also be modeled as a time-series of fully correlated random variables:

$$\boldsymbol{\rho}_{k+1} = \boldsymbol{\rho}_k,$$

resulting in

$$\boldsymbol{\rho}_k \sim N(\hat{\boldsymbol{\rho}}, \mathbf{P}^\rho), \quad \mathrm{cov}(\boldsymbol{\rho}_k, \boldsymbol{\rho}_1) = \mathbf{P}^\rho.$$

As shown in Figure 2, inferential sensor 210 can include an error vector stacking module 218. Error vector stacking module 218 can determine overall error vector $\mathbf{e}_k$ based on the errors associated with measurement model 214 and dynamic model 216. As used herein, a "module" can include computer readable instructions that can be executed by a processing resource (e.g., processor 102 previously described in connection with Figure 1) to perform a particular function. A module can also include hardware, firmware, and/or logic that can perform a particular function.

As shown in Figure 2, inferential sensor 210 can include a weighting matrix computation module 220. Weighting matrix computation module 220 can receive an estimated state sequence. Weighting matrix computation module 220 can also receive a description of the model parameters uncertainty, and a description of the model noise. Based on these inputs, weighting matrix computation module 220 can determine (e.g., compute) non-diagonal weighting matrix $\mathbf{W}$, which will be further described herein.

As shown in Figure 2, inferential sensor 210 can include an error weighting module 222. Error weighting module 222 can receive measurement noise vector $\mathbf{e}_k$ from error vector stacking module 218, and non-diagonal weighting matrix $\mathbf{W}$ from weighting matrix computation module 220. Based on these inputs, error weighting module 222 can determine a minimized variable:

$$J = \mathbf{e}^T \mathbf{W} \mathbf{e}$$

As shown in Figure 2, inferential sensor 210 can include a numerical optimization module 224. Numerical optimization module 224 can receive the minimized variable $J$ from error weighting module 222, and the constraints on the variable to be estimated. Based on these inputs, numerical optimization module 224 can estimate the variable that is not directly measurable. For example, numerical optimization module 224 can generate an estimated state sequence that includes both the current state of the variable and a prediction of the future state(s) of the variable.

As an example, given the previously described description of measurement model 214 and dynamic model 216, an input sequence of $\mathbf{u}_1, \mathbf{K}, \mathbf{u}_N$, an output sequence of $\mathbf{y}_1, \mathbf{K}, \mathbf{y}_N$, constraints on states $\mathbf{x}_k \in C$, and prior information on the state estimate in the form of mean value $\hat{\mathbf{x}}_{1|0}$, variance $\mathbf{P}_{1|0}^{\mathbf{x}}$, and covariance with uncertain parameters $\mathbf{P}_{1|0}^{\mathbf{x}\rho}$ :

$$\mathbf{x}_{1|0} \sim N\left(\hat{\mathbf{x}}_{1|0}, \mathbf{P}_{1|0}^{\mathbf{x}}\right), \quad \mathrm{cov}\left(\mathbf{x}_{1|0}, \rho\right) = \mathbf{P}_{1|0}^{\mathbf{x}\rho}.$$

Numerical optimization module 224 can generate an estimated state sequence $\hat{\mathbf{x}}_1, \mathbf{K}, \hat{\mathbf{x}}_{N+1}$ by solving the optimization problem:

$$\min_{\hat{\mathbf{x}}_1, \mathbf{K}, \hat{\mathbf{x}}_{N+1}} \begin{pmatrix} \hat{\mathbf{x}}_1 - \hat{\mathbf{x}}_{1|0} \\ \hat{\mathbf{x}}_2 - f(\hat{\mathbf{x}}_1, \mathbf{u}_1, \hat{\rho}) \\ \mathbf{M} \\ \hat{\mathbf{x}}_{N+1} - f(\hat{\mathbf{x}}_N, \mathbf{u}_N, \hat{\rho}) \\ \mathbf{y}_1 - g(\hat{\mathbf{x}}_1, \mathbf{u}_1, \hat{\rho}) \\ \mathbf{M} \\ \mathbf{y}_N - g(\hat{\mathbf{x}}_N, \mathbf{u}_N, \hat{\rho}) \end{pmatrix}^T \mathbf{W} \begin{pmatrix} \hat{\mathbf{x}}_1 - \hat{\mathbf{x}}_{1|0} \\ \hat{\mathbf{x}}_2 - f(\hat{\mathbf{x}}_1, \mathbf{u}_1, \hat{\rho}) \\ \mathbf{M} \\ \hat{\mathbf{x}}_{N+1} - f(\hat{\mathbf{x}}_N, \mathbf{u}_N, \hat{\rho}) \\ \mathbf{y}_1 - g(\hat{\mathbf{x}}_1, \mathbf{u}_1, \hat{\rho}) \\ \mathbf{M} \\ \mathbf{y}_N - g(\hat{\mathbf{x}}_N, \mathbf{u}_N, \hat{\rho}) \end{pmatrix} \text{ s.t. } \begin{pmatrix} \hat{\mathbf{x}}_1 \\ \mathbf{M} \\ \hat{\mathbf{x}}_{N+1} \end{pmatrix} \in C,$$

where **W** is the non-diagonal error weighting matrix, given by:

$$\mathbf{W} = \left(\mathbf{T}\mathbf{P}^z\mathbf{T}^\mathrm{T}\right)^{-1},$$

**T** is the transformation matrix and **P** is the joint covariance matrix:

$$\mathbf{T} = \begin{pmatrix} \mathbf{I} & & & \\ \mathbf{M}_1 & \mathbf{I} & & \\ \mathbf{M} & \mathbf{O} & & \\ \mathbf{M}_N & & \mathbf{I} & \\ \mathbf{N}_1 & & & \mathbf{I} \\ \mathbf{M} & & & \mathbf{O} \\ \mathbf{N}_N & & & \mathbf{I} \end{pmatrix}, \quad \mathbf{P} = \begin{pmatrix} \mathbf{P}_{1|0}^{\mathbf{x}} & \mathbf{P}_{1|0}^{\mathbf{x}\rho} & & & \\ \mathbf{P}_{1|0}^{\rho\mathbf{x}} & \mathbf{P}^{\rho} & & & \\ & & \mathbf{Q}_1 & & \\ & & & \mathbf{O} & \\ & & & \mathbf{Q}_N & \\ & & & & \mathbf{R}_1 \\ & & & & \mathbf{O} \\ & & & & \mathbf{R}_N \end{pmatrix},$$

where $\mathbf{M}_k$ and $\mathbf{N}_k$ are the model linearization matrices:

$$\mathbf{M}_k = \frac{\partial f(\mathbf{x}_k, \mathbf{u}_k, \hat{\boldsymbol{\rho}})}{\partial \boldsymbol{\rho}}, \quad \mathbf{N}_k = \frac{g(\mathbf{x}_k, \mathbf{u}_k, \hat{\boldsymbol{\rho}})}{\partial \boldsymbol{\rho}}.$$

It is noted that the optimization problem reduces to the Kalman filter for models with uncertain parameters if $N$ = 1 and if the constraint set $C$ is empty, and that the optimization problem further reduces to the standard Kalman filter if $N$ = 1, the constraint set $C$ is empty, and the covariance matrices $\mathbf{P}^\rho$ and $\mathbf{P}^{\mathbf{x}\rho}_{1|0}$ are zero.

As such, numerical optimization module 224 can continuously adjust (e.g., update) the estimated state sequence to minimize the weighted measurement model error and the dynamic model error on the historic horizon of the last $N$ direct measurements. The errors can be mutually weighted using a quadratic form with a non-diagonal weighting matrix (e.g., $\mathbf{W}$). In some embodiments, the weighting matrix can be based on the model parameters uncertainty description and the model noise description such that the estimated state sequence has minimal mean square error. Further, the numerical optimization can include constraints on the estimated state sequence.

Figure 3 illustrates a system 330 for estimating variables that are not directly measurable in accordance with one or more embodiments of the present disclosure. System 330 can include a number (e.g., plurality) of inferential sensors 310-1, 310-2, ..., 310-N, as illustrated in Figure 3. Each respective inferential sensor 310-1, 310-2, ..., 310-N can be analogous to inferential sensor 210 previously described in connection with Figure 2, and can estimate variables that are not directly measurable in a manner analogous to that previously described herein (e.g., in connection with Figures 1 and 2).

In the embodiment illustrated in Figure 3, inferential sensors 310-1, 310-2, ..., 310-N are a portion of a computing device 332. However, embodiments of the present disclosure are not so limited. For example, in some embodiments, each respective inferential sensor 310-1, 310-2, . .., 310-N can be an individual, stand-alone inferential sensor.

As shown in Figure 3, system 330 can include a number (e.g., plurality) of batteries 334-1, 334-2, ..., 334-N, which can comprise a battery pack. Each respective battery 334-1, 334-2, ..., 334-N can be associated with (e.g., coupled to) a inferential sensor 310-1, 310-2, ..., 310-N. For instance, in the embodiment illustrated in Figure 3, battery 334-1 is associated with inferential sensor 310-1, battery 334-2 is associated with inferential sensor 310-2, and battery 334-N is associated with inferential sensor 310-N.

A battery (e.g., batteries 334-1, 334-2, ..., 334-N) can be a device comprising one or more electrochemical cells that convert stored chemical energy into electrical energy (e.g., as in discharging) and/or convert electrical energy into stored chemical energy (e.g., as in recharging). Further "battery," as used herein, can refer to one or more electrochemical cells of a battery. For example, batteries can include one or more cells of lithium-ion batteries (e.g., lithium cobalt oxide, lithium iron phosphate, lithium manganese oxide, lithium nickel manganese cobalt oxide, lithium nickel cobalt aluminum oxide, and/or lithium titanate, etc.) among others.

As shown in Figure 3, system 330 can include a number (e.g., plurality) of temperature sensors 336-1, 336-2, ..., 336-N. Each respective temperature sensor 336-1, 336-2, ..., 336-N can be associated with (e.g., coupled to) a different inferential sensor 310-1, 310-2, ..., 310-N, and can sense the temperature associated with (e.g., of) a different battery 334-1, 334-2, ..., 334-N. For instance, in the embodiment illustrated in Figure 3, temperature sensor 336-1 is associated with inferential sensor 310-1 and senses the temperature associated with battery 334-1, temperature sensor 336-2 is associated with inferential sensor 310-2 and senses the temperature associated with battery 334-2, and temperature sensor 336-N is associated with inferential sensor 310-N and senses the temperature associated with battery 334-N.

As shown in Figure 3, system 330 can include a current sensor 338 coupled to computing device 332 and in series with batteries 334-1, 334-2, ..., 334-N. Current sensor 338 can sense the current associated with batteries 334-1, 334-2, ..., 334-N.

Each respective inferential sensor 310-1, 310-2, ..., 310-N can receive direct measurements of a number of variables, wherein each variable is a different characteristic associated with its respective battery. For example, inferential sensor 310-1 can receive direct measurements of characteristics associated with battery 334-1, inferential sensor 310-2 can receive direct measurements of characteristics associated with battery 334-2, and inferential sensor 310-N can receive direct measurements of characteristics associated with battery 334-N.

The variables (e,g., characteristics) can include, for example, the voltage, current, and/or temperature associated with each respective battery 334-1, 334-2, ..., 334-N. The current associated with batteries 334-1, 334-2, ..., 334-N can be received from current sensor 338, and the temperature associated with each respective battery can be received from temperature sensors 336-1, 336-2, ..., 336-N. For instance, inferential sensor 310-1 can receive direct measurements of the temperature associated with battery 334-1 from temperature sensor 336-1, inferential sensor 310-2 can receive direct measurements of the temperature associated with battery 334-2 from temperature sensor 336-2, inferential sensor 310-N can receive direct measurements of the temperature associated with battery 334-N from temperature sensor 336-N, and each respective inferential sensor 310-1, 310-2, ..., 310-N can receive direct measurements of the current associated with its respective battery from current sensor 338. Further, although not shown in Figure 3 for clarity and so as not to obscure embodiments of the present disclosure, inferential sensor 310-1 can receive direct measurements of the voltage associated with battery 334-1 from a voltage sensor associated with battery 334-1, inferential sensor 310-2 can receive direct measurements of the voltage associated with battery 334-2 from a voltage sensor associated with battery 334-2, and inferential sensor 310-N can receive direct measurements of the voltage associated with battery 334-N from a voltage sensor associated with battery 334-N.

Each respective inferential sensor 310-1, 310-2, ..., 310-N can estimate an internal state of its respective battery based on the direct measurements received by that inferential sensor. For example, inferential sensor 310-1 can estimate an internal state of battery 334-1 based on the direct measurements of the characteristics associated with battery 334-1, inferential sensor 310-2 can estimate an internal state of battery 334-2 based on the direct measurements of the characteristics associated with battery 334-2, and inferential sensor 310-N can estimate an internal state of battery 334-N based on the direct measurements of the characteristics associated with battery 334-N.

The internal state can be a variable (e.g., characteristic) of the battery that may not be directly measurable. For example, the internal state can be and/or include the remaining charge of the battery and/or the state of health (e.g., capacity fade) of the battery, among others.

The internal state can be estimated using an inferential sensor with a model having a number of uncertain parameters associated therewith, and a number of constraints on the internal state. The model can be, for example, a mathematical model that describes a relationship, such as, for instance, a dynamical coupling, between the internal state of the battery and the directly measured variables (e.g., the voltage, current, and/or temperature of the battery), as previously described herein. Further, a single (e.g., the same) model may be used for each inferential sensor. That is, each respective inferential sensor 310-1, 310-2, ..., 310-N can use the same model to estimate the internal state of its respective battery.

The uncertain parameters associated with the model can be parameters associated with batteries 334-1, 334-2, ..., 334-N that are described by their probability distributions (e.g., by their mean value and covariance), and are not updated by new measurements of the directly measurable variables, as previously described herein. For instance, the uncertain parameters can include parameters associated with batteries 334-1, 334-2, ..., 334-N that may have manufacturing variability (e.g., parameters that capture and/or may vary between the batteries due to manufacturing variability) such as, for instance, the capacity and the internal resistance associated with the batteries.

The constraints on the internal state of the batteries that are incorporated by the MHE can include a number of physical constraints on the internal state, and/or a number of constraints on the validity range of the model. For instance, the constraints on the internal state of the batteries may include a constraint of 0% to 100% on the remaining charge of the batteries, since it is not possible for the remaining charge of the batteries to be less than 0% or greater than 100%. Further, the MHE may include a non-diagonal weighting matrix to minimize errors associated with the model, as previously described herein.

In some embodiments, inferential sensors 310-1, 310-2, ..., 310-N can estimate the internal states of batteries 334-1, 334-2, ..., 334-N based on a current direct measurement of each respective directly measurable variable, and a number of previous (e.g., historic) direct measurements of each respective directly measurable variable, in a manner analogous to that previously described herein. Further, in some embodiments the estimation of the internal states may include an estimate of the current internal states, and a prediction of future (e.g., the next) internal states, in a manner analogous to that previously described herein.

Although the example system illustrated in Figure 3 relates to estimating the internal state of batteries, embodiments of the present disclosure are not so limited, and can be applicable to any application or field involving estimation of variables that are not directly measurable. For example, embodiments of the present disclosure can be applicable to navigation systems, industrial process control systems, sensor data fusion, automotive, machine, computer, and/or weather forecast applications or fields, among others.

Although specific embodiments have been illustrated and described herein, those of ordinary skill in the art will appreciate that any arrangement calculated to achieve the same techniques can be substituted for the specific embodiments shown. This disclosure is intended to cover any and all adaptations or variations of various embodiments of the disclosure.

It is to be understood that the above description has been made in an illustrative fashion, and not a restrictive one. Combination of the above embodiments, and other embodiments not specifically described herein will be apparent to those of skill in the art upon reviewing the above description.

The scope of the various embodiments of the disclosure includes any other applications in which the above structures and methods are used. Therefore, the scope of various embodiments of the disclosure should be determined with reference to the appended claims, along with the full range of equivalents to which such claims are entitled.

In the foregoing Detailed Description, various features are grouped together in example embodiments illustrated in the figures for the purpose of streamlining the disclosure. This method of disclosure is not to be interpreted as reflecting an intention that the embodiments of the disclosure require more features than are expressly recited in each claim.

Rather, as the following claims reflect, inventive subject matter lies in less than all features of a single disclosed embodiment. Thus, the following claims are hereby incorporated into the Detailed Description, with each claim standing on its own as a separate embodiment.

**Claims**

1. A computing device (100) for estimating variables that are not directly measurable, comprising:

   a memory (104); and
   a processor (102) configured to execute executable instructions stored in the memory (104) to estimate a number of variables that are not directly measurable using an inferential sensor (210, 310-1, 310-2, ..., 310-N) with:

      a model (214, 216) having a number of uncertain parameters associated therewith, wherein the model (214, 216) describes a relationship between the number of variables to be estimated and a number of directly measurable variables; and
      a number of constraints on the number of variables to be estimated.

2. The computing device (100) of claim 1, wherein the number of uncertain parameters are described by probability distributions and are not updated by new measurements of the directly measurable variables.

3. The computing device (100) of claim 1, wherein the number of constraints include a number of physical constraints on the number of variables to be estimated.

4. The computing device (100) of claim 1, wherein the number of constraints include a number of constraints on a validity range of the model (214, 216).

5. The computing device (100) of claim 1, wherein the processor (102) is configured to execute the instructions to estimate the number of variables that are not directly measurable based on:

      a current direct measurement of each respective directly measurable variable; and
      a number of previous direct measurements of each respective directly measurable variable.

6. The computing device (100) of claim 1, wherein the estimation of the number of variables that are not directly measurable includes:

      an estimation of a current state of the variables; and
      a prediction of a future state of the variables.

7. The computing device (100) of claim 1, wherein the processor (102) is configured to execute the instructions to use a non-diagonal weighting matrix (220) to minimize errors associated with the model (214, 216).

8. The computing device (100) of claim 7, wherein the non-diagonal weighting matrix (220) minimizes a mean square error of an estimated state sequence for the model (214, 216).

9. The computing device (100) of claim 1, wherein:

      the computing device (100) includes a user interface (106); and
      the processor (102) is configured to execute the instructions to display the estimate of the number of variables on the user interface (106).

10. The computing (100) device of claim 1, wherein the processor (102) is configured to execute the instructions to store the estimate of the number of variables in the memory (104).

11. A method for estimating variables that are not directly measurable, comprising:

      estimating a number of variables that are not directly measurable using an inferential sensor (210, 310-1, 310-2, ..., 310-N) with:

a model (214, 216) having a number of uncertain parameters associated therewith, wherein the model (214, 216) describes a relationship between the number of variables to be estimated and a number of directly measured variables; and

a number of constraints on the number of variables to be estimated.

**12.** The method of claim 11, wherein the number of variables that are not directly measurable include an internal state of a battery (334-1, 334-2, ..., 334-N).

**13.** The method of claim 11, wherein the number of directly measured variables include a number of characteristics associated with a battery (334-1, 334-2, ..., 334-N).

**14.** The method of claim 11, wherein the number of uncertain parameters associated with the model (214, 216) include parameters associated with a battery (334-1, 334-2, ..., 334-N) that have manufacturing variability.

**15.** The method of claim 11, wherein the method includes receiving a direct measurement of the number of directly measured variables.

**Amended claims in accordance with Rule 137(2) EPC.**

**1.** A computing device (100) for estimating variables that are not directly measurable, comprising:

a memory (104); and

a processor (102) configured to execute executable instructions stored in the memory (104) to estimate a number of variables that are not directly measurable using an inferential sensor (210, 310-1, 310-2, ..., 310-N) with:

a model (214, 216) having a number of uncertain parameters associated therewith, wherein the model (214, 216) describes a relationship between the number of variables to be estimated and a number of directly measurable variables; and

a number of constraints on the number of variables to be estimated, wherein:

the number of variables that are not directly measureable and are to be estimated include a remaining charge of a battery (334-1, 334-2, ..., 334-N);

the number of uncertain parameters associated with the model include a capacity and an internal resistance of the battery (334-1, 334-2, ..., 334-N); and

the number of directly measurable variables include a voltage, current, or temperature associated with the battery (334-1, 334-2, ..., 334-N) and sensed by a sensor (336-1, 336-2, ..., 336-N, 338); and

a user interface (106) configured to display the estimated remaining charge of the battery (334-1, 334-2, ..., 334-N) to a user.

**2.** The computing device (100) of claim 1, wherein the number of uncertain parameters are described by probability distributions and are not updated by new measurements of the directly measurable variables.

**3.** The computing device (100) of claim 1, wherein the number of constraints include a number of physical constraints on the number of variables to be estimated.

**4.** The computing device (100) of claim 1, wherein the number of constraints include a number of constraints on a validity range of the model (214, 216).

**5.** The computing device (100) of claim 1, wherein the processor (102) is configured to execute the instructions to estimate the number of variables that are not directly measurable based on:

a current direct measurement of each respective directly measurable variable; and

a number of previous direct measurements of each respective directly measurable variable.

**6.** The computing device (100) of claim 1, wherein the estimation of the number of variables that are not directly measurable includes:

an estimation of a current state of the variables; and
a prediction of a future state of the variables.

7. The computing device (100) of claim 1, wherein the processor (102) is configured to execute the instructions to use a non-diagonal weighting matrix (220) to minimize errors associated with the model (214, 216).

8. The computing device (100) of claim 7, wherein the non-diagonal weighting matrix (220) minimizes a mean square error of an estimated state sequence for the model (214, 216).

9. The computing (100) device of claim 1, wherein the processor (102) is configured to execute the instructions to store the estimate of the number of variables in the memory (104).

10. A method for estimating variables that are not directly measurable, comprising:

estimating a number of variables that are not directly measurable using an inferential sensor (210, 310-1, 310-2, ..., 310-N) with:

a model (214, 216) having a number of uncertain parameters associated therewith, wherein the model (214, 216) describes a relationship between the number of variables to be estimated and a number of directly measured variables; and
a number of constraints on the number of variables to be estimated, wherein:

the number of variables that are not directly measureable and are to be estimated include a remaining charge of a battery (334-1, 334-2, ..., 334-N);
the number of uncertain parameters associated with the model include a capacity and an internal resistance of the battery (334-1, 334-2, ..., 334-N); and
the number of directly measurable variables include a voltage, current, or temperature associated with the battery (334-1, 334-2, ..., 334-N) and sensed by a sensor (336-1, 336-2, ..., 336-N, 338); and

displaying the estimated remaining charge of the battery on a user interface (106) to a user.

11. The method of claim 10, wherein the capacity and the internal resistance of the batter (334-1, 334-2, ..., 334-N) have manufacturing variability.

12. The method of claim 10, wherein the method includes receiving a direct measurement of the number of directly measured variables.

**Fig. 1**

*Fig. 2*

*Fig. 3*

## EP 3 252 616 A1

Europäisches Patentamt

European Patent Office

Office européen des brevets

**EUROPEAN SEARCH REPORT**

Application Number

EP 16 17 2548

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Murali R Rajamani: "Data-based techniques to improve state estimation in model predictive control", PhD. Thesis, 2007, pages 1-257, XP055341547, Retrieved from the Internet: URL:http://jbrwww.che.wisc.edu/theses/rajamani.pdf [retrieved on 2017-02-02] * pages 2, 6, 23, 31 and 174 section 2.1.1 * | 1-15 | INV. G06F17/18 G01R31/36 |
| X | MA YAN ET AL: "Lithium-ion battery state of charge estimation based on moving horizon", PROCEEDING OF THE 11TH WORLD CONGRESS ON INTELLIGENT CONTROL AND AUTOMATION, IEEE, 29 June 2014 (2014-06-29), pages 5002-5007, XP032742560, DOI: 10.1109/WCICA.2014.7053563 [retrieved on 2015-03-02] * section III * | 1-15 | |
| X | ZHANG CAIPING ET AL: "Robust and Adaptive Estimation of State of Charge for Lithium-Ion Batteries", IEEE TRANSACTIONS ON INDUSTRIAL ELECTRONICS, IEEE SERVICE CENTER, PISCATAWAY, NJ, USA, vol. 62, no. 8, August 2015 (2015-08), pages 4948-4957, XP011585857, ISSN: 0278-0046, DOI: 10.1109/TIE.2015.2403796 [retrieved on 2015-06-26] * section VI * | 1-15 | TECHNICAL FIELDS SEARCHED (IPC) G06F G01R |

-/--

The present search report has been drawn up for all claims

| Place of search | Date of completion of the search | Examiner |
|---|---|---|
| Berlin | 6 February 2017 | Huguet Serra, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Europäisches Patentamt
European Patent Office
Office européen des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUIMIN CHEN: "Adaptive cubature Kalman filter for nonlinear state and parameter estimation", INFORMATION FUSION (FUSION), 2012 15TH INTERNATIONAL CONFERENCE ON, IEEE, 9 July 2012 (2012-07-09), pages 1413-1420, XP032228582, ISBN: 978-1-4673-0417-7 * sections II, III and IV * | 1-15 | |
| A | NACHI GUPTA ET AL: "Kalman Filtering with Equality and Inequality State Constraints", ARXIV.ORG, CORNELL UNIVERSITY LIBRARY, 201 OLIN LIBRARY CORNELL UNIVERSITY ITHACA, NY 14853, 18 September 2007 (2007-09-18), XP080302311, * sections 3 and 4 * | 1-15 | |
| A | ERIC L. HASELTINE ET AL: "Critical Evaluation of Extended Kalman Filtering and Moving-Horizon Estimation", INDUSTRIAL & ENGINEERING CHEMISTRY RESEARCH., vol. 44, no. 8, 12 March 2003 (2003-03-12), pages 2451-2460, XP055340103, US ISSN: 0888-5885, DOI: 10.1021/ie0343081 * the whole document * | 1-15 | TECHNICAL FIELDS SEARCHED (IPC) |
| A | US 2005/110498 A1 (PLETT GREGORY L [US]) 26 May 2005 (2005-05-26) * the whole document * | 1-15 | |
| A | CN 104 242 393 A (ANHUI LIGHT ENERGY TECHNOLOGY RES INST CO LTD) 24 December 2014 (2014-12-24) * the whole document * | 1-15 | |

The present search report has been drawn up for all claims

| Place of search | Date of completion of the search | Examiner |
|---|---|---|
| Berlin | 6 February 2017 | Huguet Serra, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 16 17 2548

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2017

| Patent document cited in search report | | | Publication date | Patent family member(s) | | | Publication date |
|---|---|---|---|---|---|---|---|
| US 2005110498 | A1 | | 26-05-2005 | BR | PI0416652 | A | 16-01-2007 |
| | | | | CA | 2547012 | A1 | 02-06-2005 |
| | | | | CN | 1883097 | A | 20-12-2006 |
| | | | | EP | 1692754 | A1 | 23-08-2006 |
| | | | | JP | 4722857 | B2 | 13-07-2011 |
| | | | | JP | 2007517190 | A | 28-06-2007 |
| | | | | KR | 20060107535 | A | 13-10-2006 |
| | | | | RU | 2336618 | C2 | 20-10-2008 |
| | | | | TW | I281298 | B | 11-05-2007 |
| | | | | US | 2005110498 | A1 | 26-05-2005 |
| | | | | US | 2008094035 | A1 | 24-04-2008 |
| | | | | US | 2010174500 | A1 | 08-07-2010 |
| | | | | WO | 2005050810 | A1 | 02-06-2005 |
| CN 104242393 | A | | 24-12-2014 | NONE | | | |

EPO FORM P0459

For more details about this annex : see Official Journal of the European Patent Office, No. 12/82